# EUROPEAN PATENT APPLICATION

(11) **EP 0 543 426 A1**
(43) Date of publication of application: **26.05.1993**
(21) Application number: 92122153.7
(22) Date of filing: 11.07.1983
(51) Int. Cl.: H03K 19/01, H03K 19/094

(54) **Gate circuit of combined field-effect and bipolar transistors**

(30) Priority: 12.07.1982 JP 119815/82
(62) Divisional of application: 87118836.3
(71) Applicant: HITACHI, LTD., Chiyoda-ku, Tokyo 101 (JP)
(72) Inventor: Masuda, Ikuro, Hitachi-shi (JP); Kato, Kazuo, Naka-gun, Ibaraki-ken (JP); Sasayama, Takao, Hitachi-shi (JP); Nishio, Yoji, Hitachi-shi (JP); Kuboki, Shigeo, Nakaminato-shi (JP); Iwamura, Masahiro, Hitachi-shi (JP)
(74) Representative: Patentanwälte Beetz - Timpe - Siegfried Schmitt-Fumian - Mayr

(57) **Abstract**

The invention relates to a high-speed, low-power consumption gate circuit comprising a combination of complementary field-effect and bipolar transistors (10, 11; 14, 15) and discharge means (12) for discharging accumulated charges from these transistors when they are turned off.

The circuit structure may comprise additional field-effect transistors (123). The circuit structure can be provided in the form of an integrated circuit, wherein the bipolar transistor is preferably of vertical type.

## Description

This invention relate, to gate circuits formed of a combination of field-effect and bipolar transistors.

There is known a gate circuit formed of a combination of field-effect transistors and bipolar transistors so as to achieve high-speed operation and low-power consumption, for example, an inverter circuit shown in Fig. 1 (See JP-A-54-148469).

This inverter circuit is formed of a P-channel metal (silicon)-oxide-semiconductor field-effect-transistor (hereinafter referred to simply as PMOS) 50, an N-channel metal (silicon)-oxide-semiconductor field-effect-transistor (hereinafter referred to simply as NMOS) 51, an NPN-transistor 53, and a PNP transistor 54.

In this inverter circuit, when the input 55 is at "0" level, the PMOS 50 is turned on but the NMOS 51 off. Consequently, the base potential of the NPN transistor 53 and the PNP transistor 54 is increased to turn on the NPN transistor 53 but turn off the PNP transistor 54, and thus the output 56 becomes "1" level. When the input 55 is at "1" level, the PMOS 50 is turned off but the NMOS 51 on. Consequently, the base potential of the NPN transistor 53 and the PNP transistor 54 is reduced to turn off the NPN transistor 53 but turn on the PNP transistor 54, and thus the output 56 becomes "0" level.

However, since the bipolar transistors 53 and 54 used are complementary and difficult to be matched in their switching characteristics, the trailing edge of the output signal 56 is delayed. This is because the PNP transistor of the complementary transistors is inferior in its performances such as current amplification factor to the NPN transistor.

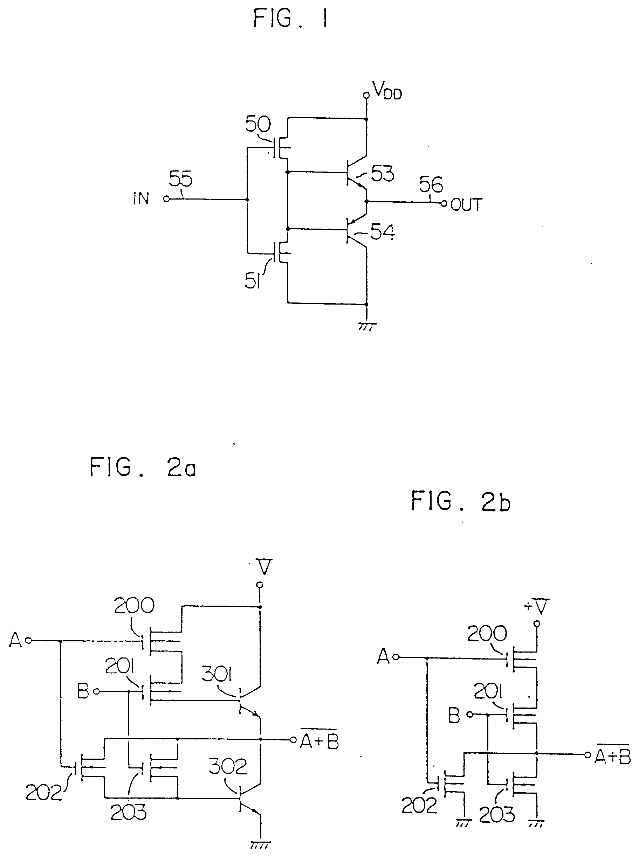

There is also known a 2-input NOR gate circuit shown in Fig. 2a (IEEE. Trans. Electron Devices, vol. ED-16, No. 11, pp. 945-951, Nov. 1969). This 2-input NOR circuit is a combination of a C-MOS transistor NOR gate circuit having PMOSs 200 and 201 and NMOSs 202 and 203 as shown in Fig. 2b, and NPN transistors 301 and 302. In this 2-input NOR gate circuit, when the NPN transistors 301 and 302 are turned off from the ON-state, the time required for the switching from the ON-state to the OFF-state is long because there are no means for forcibly extracting or drawing out minority charges accumulated on the bases of the NPN transistors 301 and 302. Thus, the first and second NPN transistors 301 and 302 remain long in the ON-state, so that the switching time as well as the power consumption increase.

Accordingly, it is an object of this invention to provide a high-speed, low-power consumption gate circuit formed of field-effect and bipolar transistors and its implementation in integrated form to obviate the problems encountered in C-MOS circuits and bipolar transistor circuits.

The above object is achieved according to claim 1.

The dependent claims relate to preferred embodiments.

The composite bipolar transistor-complementary field-effect transistor logic gate circuit according to the invention comprises
A) a bipolar transistor having a collector of a first conductivity type connected to a first potential terminal, a base of a second conductivity type, and an emitter of the first conductivity type connected to an output terminal,
B) k(k ≧1) FETs of the second conductivity type for forming a current path from the first potential terminal to the base of the bipolar transistor, in response to input signals applied to the respective input terminal of k input terminals,
   and
C) k switching means connected between the output terminal and a second potential terminal, and connected to the input terminals;
it is characterized by
D) discharge means connected to the base of the bipolar transistor.

In accordance with a prefered embodiment, the circuit is characterized in that the k FETs of the second conductivity type have their gates connected to the corresponding input terminal, for k = 1 source and drain of the FET being connected between collector and base of the first bipolar transistor, respectively, and for k ≧ 2 their sources and drains being connected in parallel or in series between collector and base of the first bipolar transistor, respectively.

In accordance with another prefered embodiment, the circuit is characterized in that the switching means comprise:
- A second bipolar transistor having its collector being of the first conductivity type connected to the output terminal and its emitter being of the first conductivity type connected to the second potential terminal, and having a base of the second conductivity type,
- k second FETs of the first conductivity type having their gates connected to the corresponding input terminal, for k = 1 drain and source of the FET being connected between collector and base of the second bipolar transistor, respectively, and for k ≧ 2 their drains and sources being connected in series or in parallel between collector and base of the second bipolar transistor, respectively,
   and
- second discharge means connected to the base of the second bipolar transistor.

According to a further prefered embodiment of the above circuit, the second discharge means are a resistor, one terminal of the resistor being connected to the base of the second bipolar transistor, the other terminal of the resistor being connected to the second potential terminal.

In the circuit according to the invention, the bipolar transistor can be implemented as a vertical type transistor formed as an island in a substrate of the second conductivity type.

Composite bipolar transistor-complementary field-effect transistor logic gate circuits comprising two bipolar transistors, and corresponding latch circuits are subject-matter of the European patent EP 99 100 (EP application no. 83 106 796.2) which particularly relates to various realizations of first and second discharge means, without implementation in an integrated circuit structure.

The implementation of the circuits according to EP 99 100 in integrated circuit structures is subject-matter of the parent patent EP 279 943. The composite bipolar transistor-complementary field-effect transistor logic gate circuits of the parent patent comprise:
A) A semiconductor substrate;
B) a first bipolar transistor having a collector of a first conductivity type connected to a first potential, an emitter of the first conductivity type connected to an output terminal, and a base of a second conductivity type;
C) a second bipolar transistor having its collector of the first conductivity type connected to the output terminal, an emitter of the first conductivity type connected to a second potential, and a base of the second conductivity type;
D) k input terminals (k ≧ 1);
E) k field-effect transistors of the second conductivity type having their gates connected to each of the input terminals, respectively, and their sources and drains connected between the base and the collector of the first bipolar transistor, respectively and
F) k field-effect transistors of the first conductivity type having their gates connected to each of the input terminals, respectively, and their sources and drains connected between the base and the collector of the second bipolar transistor and are characterized in that
G) first discharge means are provided connected to the base of the first bipolar transistor for discharging charges accumulated in the first bipolar transistor when the first bipolar transistor is switched from the on-state to the off-state;
H) second discharge means are provided connected to the base of the second bipolar transistor for discharging from the base charges accumulated in said second bipolar transistor when said second bipolar transistor is switched from the on-state to the off-state,
I) the substrate is of the second conductivity type,
J) the first and second bipolar transistors are each of a vertical type formed respectively in semiconductor regions of the first conductivity type isolated from one another by means of the semiconductor substrate, and
K) the base regions of the first and second bipolar transistors are isolated from the source, drain and channel regions of the field-effect transistors.

In the following, the invention will be explained with reference to embodiments and the accompanying drawings, wherein for a better understanding and because of the relation between EP 99 100 and the present subject-matter, reference is also made to the subject-matter of this patent, because the concept of this invention can be applied to the circuit principle according to this patent.
Fig. 3 is a circuit diagram showing a logic gate circuit in the form of an inverter according to EP 99 100;
Fig. 4 is a schematic diagram showing a cross-section of the logic gate circuit of Fig. 3, implemented in an integrated circuit structure according to one aspect of this invention;
Figs. 5 - 7 are circuit diagrams showing NAND, NOR and latch circuits, respectively, according to EP 99 100;
Figs. 8 - 10 are circuit diagrams showing inverter circuits according to EP 99 100;
Figs. 11 - 13 are circuit diagrams of inverter circuits according to different embodiments of this invention; and
Figs. 14 - 16 are circuit diagrams of inverter NAND and NOR circuits, respectively, according to EP 99 100.

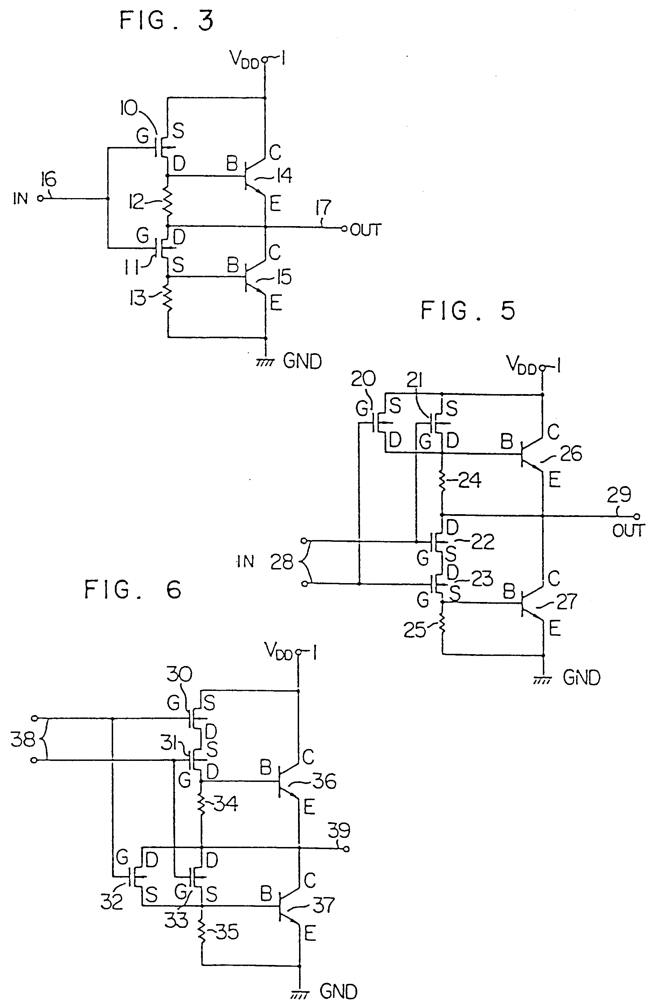

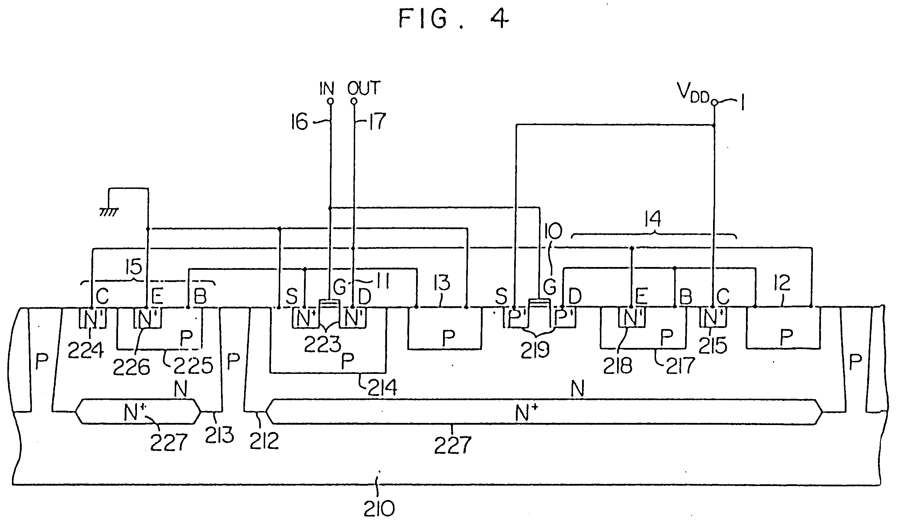

The inverter circuit shown in Fig. 3 comprises a first bipolar NPN transistor 14 having its collector electrode C connected to a power supply terminal 1 at which a first fixed potential V_{DD} is maintained, and its emitter electrode E connected to an output terminal 17. The collector electrode C of a second bipolar NPN transistor 15 is connected to the output terminal 17 and its emitter electrode E connected to ground potential GND as a second fixed potential. The gate electrode G of a P-channel metal (silicon)-oxide-semiconductor field-effect-transistor (hereinafter, referred to simply as PMOS) 10 is connected to an input terminal 16, its source electrode S and its drain electrode D being respectively connected to the collector electrode C and the base electrode B of the first NPN transistor 14. Furthermore, the circuit comprises an N-channel metal (silicon)-oxide-semiconductor field-effect transistor (hereinafter, referred to simply as NMOS) 11 having its gate electrode G connected to the input terminal 16, and its drain electrode D and source electrode S respectively connected to the collector electrode C and the base electrode B of the second NPN transistor 15. A resistor 12 connects the drain electrode D of the PMOS 10 with the drain electrode D of the NMOS 11, and the resistor 13 connects the base electrode B with the emitter electrode E of the second NPN transistor 15.

Fig. 4 schematically shows the cross-section of the implementation of the inverter circuit illustrated in Fig. 3 in a semiconductor integrated circuit structure according to the invention. The PMOS 10, the first NPN transistor 14, resistors 12 and 13 and the NMOS 11 are formed in an island 212 of a semiconductor substrate 210, and the second NPN transistor 15 in an island 213 thereof.

Below these transistor structures a buried layer 227 is provided. A P⁺-region 219 and a gate electrode G constitute the PMOS 10, and an N⁺-region 223 and a gate electrode G within a P well 214 constitute the NMOS 11. The first NPN transistor 14 comprises a P-region 217 as its base, an N⁺-region 218 within the P-region 217 as its emitter and an N⁺-region 215 as its collector. The second NPN transistor 15 comprises a P-region 225 within the island 213 as its base, an N⁺-region 226 within the P-region 225 as its emitter, and an N⁺-region 224 as its collector. The corresponding electrodes of the NPN transistors 14 and 15 are designated with B, E and C, respectively.

In table 1 the logic operation of the inverter circuit of this embodiment are indicated.

**Table 1**

| Input 16 | PMOS 10 | NMOS 11 | NPN 14 | NPN 15 | Output 17 |
|---|---|---|---|---|---|
| "0" | ON | OFF | ON | OFF | "1" |
| "1" | OFF | ON | OFF | ON | "0" |

When the input terminal 16 is at "0" level, the PMOS 10 is turned on but the NMOS 11 off. Thus, the base potential of the first NPN transistor 14 increases to turn on the NPN transistor 14. At this time, since the NMOS 11 is turned off, the current to the second NPN transistor 15 is stopped, and the charges accumulated in the base B of the second NPN transistor 15 are drawn out through the resistor 13 to the ground, so that the second NPN transistor 15 is rapidly turned off.

Therefore, the emitter current of the first NPN transistor 14 charges the load (not shown), and the output terminal 17 rapidly becomes "1" level.

When the input terminal 16 is at "1" level, the PMOS 10 is made off but the NMOS 11 on. At this time, since the PMOS 10 is off, the current to the NPN transistor 14 stops, and the charges stored on the base of the first NPN transistor 14 and in the drain of the PMOS 10 are drawn out through the resistors 12 and 13 to the ground, so that the first NPN transistor 14 is rapidly turned off. In addition, since the NMOS 11 is on to form a short-circuit between its drain electrode D and its source electrode S, the second NPN transistor 15 is supplied at its base electrode B with the current from the output terminal 17 and with the charges stored in the base of the first NPN transistor 14 and in the drain of the PMOS 10 as mentioned above, and thereby the NPN transistor 15 is rapidly turned on. Consequently, the output terminal 17 rapidly reaches "0" level.

The function of the resistor 12 will further be described. When the PMOS 10 and the first NPN transistor 14 are switched from the ON-state to the OFF-state, the resistor 12 extracts the charges accumulated in the drain of the PMOS 10 and in the base of the first NPN transistor 14 to rapidly turn off the first NPN transistor 14, and supplies the extracted charges via the NMOS 11 in the ON-state to the base electrode B of the second NPN transistor 15 to rapidly turn on the second NPN transistor 15.

In addition, since the resistor 12 is provided between the drain of the PMOS 10 and the drain of the NMOS 11, a conductive path for causing short-circuiting is not formed between the power supply terminal 1 and GND, and thus low-power consumption in the C-MOS circuit can be achieved. In other words, if the resistor 12 were connected between the drain of the PMOS 10 and GND, a conductive path would be formed between the power supply terminal 1 and GND when the input terminal 16 is at "0" level, and thus current would always flow therethrough to increase power consumption.

Moreover, in this embodiment, since the resistor 12 is also connected to the output terminal 17, the potential at the output terminal 17, when the input terminal 16 is at "0" level, can be raised to the potential at the power supply terminal 1 through the PMOS 10 and the resistor 12, thus assuring enough noise immunity.

The function of the resistor 13 will hereinafter be described. As mentioned before, the resistor 13, when the NMOS 11 and the second NPN transistor 15 are switched from the ON-state to the OFF-state, discharges the charges accumulated in the base of the second NPN transistor 15 so as to rapidly turn off the second NPN transistor 15. Also, in this embodiment, when the input terminal 16 is at "1" level, the output terminal 17 can be brought to "0" level through the resistor 13 and the NMOS 11, thus assuring enough noise immunity.

Moreover, in this embodiment, the bipolar transistors used are of the same NPN-type, which is advantageous for obtaining uniform switching characteristics.

Furthermore, in this embodiment, since no PNP transistor with low current amplification is used, the output signal shows no trailing effect, and thus high-speed operation is ensured.

Fig. 5 shows a 2-input NAND circuit according to the parent patent to which this invention can be applied. This circuit comprises a first NPN transistor 26 having its collector electrode C connected to the power supply terminal 1, and its emitter electrode E connected to an output terminal 29, a second NPN transistor 27 having its collector electrode C connected to an output terminal 29 and its emitter electrode E connected to ground potential GND, and two input terminals 28. In addition, the gate electrodes G of PMOSs 20 and 21 are respectively connected to one and the other of the input terminals 28, their source - drain paths being connected in parallel between the collector electrode C and the base electrode B of the first NPN transistor 26 ; the gate electrodes G of NMOSs 22 and 23 are respectively connected to one and the other of the input terminals 28, and their drain - source paths are connected in series between the collector electrode C and the base electrode B of the second NPN transistor 27. A resistor 24 is connected between the common drain of the PMOSs 20 and 21 and the drain of the NMOS 22, and a resistor 25 is connected between the base and the emitter of the second NPN transistor 27.

Table 2 shows the logic operation of this embodiment.

**Table 2**

| Input 28 | PMOS 20,21 | NMOS 22,23 | NPN 26 | NPN 27 | Output 29 |
|---|---|---|---|---|---|
| Either "0" | Either ON | Either OFF | ON | OFF | "1" |
| Both "0" | Both ON | Both OFF | ON | OFF | "1" |
| Both "1" | Both OFF | Both ON | OFF | ON | "0" |

First, when either one of the input terminals 28 is at "0" level, either one of the PMOSs 20 and 21 is turned on, and either one of the NMOSs 22 and 23 is turned off. Thus, the base potential of the first NPN transistor 26 increases, and thus the NPN transistor 26 is turned on. At this time, since either one of the NMOS 22 and 23 is turned off, the current to the second NPN 27 is stopped, and the charges accumulated in the base of the second NPN transistor 27 are extracted, so that it is rapidly turned off.

Therefore, the emitter current of the first NPN transistor 26 charges the load to rapidly raise the potential of the output terminal 29 to "1" level.

When both of the input terminals 28 are at "0" level, both the PMOSs 20 and 21 are turned on, and both the NMOSs 22 and 23 are turned off. Thus, the operation is the same as above, the output terminal 29 reaching "1" level.

On the other hand, if both the input terminals 28 are at "1" level, both of the PMOSs 20 and 21 are turned off, and both NMOSs 22 and 23 are turned on. At this time, since both the PMOSs 20 and 21 are turned off, the current to the first NPN 26 stops flowing, and the charges accumulated in the base of the first NPN transistor 26 are extracted, so that it is rapidly turned off. Also, since the NMOSs 22 and 23 are turned on to form short-circuit-between the drains and sources the second NPN transistor 27 is supplied at its base electrode B with the current from the output terminal 29 and with discharge current from the base electrode B of the first NPN transistor 26 as described previously so as to rapidly turn it on. Thus, the output terminal 29 rapidly reaches "0" level.
While a 2-input NAND circuit is described in this embodiment this conception can also be applied to 3-input, 4-input and generally k-input NAND circuits (k ≧ 2) according to this invention.

Fig. 6 shows a 2-input NOR circuit according to the parent patent to which this invention can be applied.

This circuit comprises a first NPN transistor 36 having its collector electrode C connected to the power supply terminal 1 and its emitter electrode E connected to the output terminal 39, and a second NPN transistor 37 having its collector electrode C connected to the output terminal 39 and its emitter electrode E connected to ground potential GND. The gate electrodes G of two PMOSs 30 and 31 are connected to one and the other of the input terminals 38 and their source - drain paths connected in series between the collector electrode C and the base electrode B of the first NPN transistor 36. In addition, NMOSs 32 and 33 have their gate electrodes G connected to one and the other of the input terminals 38 and the drain - source paths connected in parallel between the collector electrode C and the base electrode B of the second NPN transistor 37. A resistor 34 connects the drain electrode D of the PMOS 31 with the drain electrodes D of the NMOSs 32 and 33, and a resistor 35 connects the base electrode B to the emitter electrode E of the second NPN transistor 37.

Table 3 shows the logic operation of this circuit.

**Table 3**

| Input 38 | PMOS 30,31 | NMOS 32,33 | NPN 36 | NPN 37 | Output 39 |
|---|---|---|---|---|---|
| Both "0" | Both ON | Both OFF | ON | OFF | "1" |
| Either "1" | Either OFF | Either ON | OFF | ON | "0" |
| Both "1" | Both OFF | Both ON | OFF | ON | "0" |

First, when both of the input terminals 38 are at "0" level, both the PMOSs 30 and 31 are turned on, and both the NMOSs 32 and 33 are turned off. Thus, the base potential of the first NPN transistor 36 increases, and as a result the NPN transistor 36 is turned on. At this time, since both the NMOSs 32 and 33 are turned off, the current to the second NPN transistor 37 stops flowing, and the charges accumulated in the base of the second NPN transistor 37 are extracted, so that it is rapidly turned off.

Therefore, the emitter current of the first NPN transistor 36 charges the load to rapidly raise the output terminal 39 to "1" level.

When either of the input terminals 38 is at "1" level, either of the PMOSs 30 and 31 is turned off, and either of the NMOSs 32 and 33 is turned on. At this time, since either of the PMOSs 30 and 31 is turned off, the current to the first NPN transistor 36 stops flowing, and the charges accumulated in the base of the first NPN transistor 36 are extracted, so that this transistor is rapidly turned off. In addition, since either of the NMOSs 32 and 33 is turned on to form short-curcuit between the drains and the sources the second NPN transistor 37 is supplied at its base electrode B with the current from the output terminal 39 and with the current of the charges accumulated in the base of the first NPN transistor 36 and in either of the PMOSs 30 and 31, thus rapidly turning it on. Therefore, the output terminal 39 rapidly raises to "0" level.

When both input terminals 38 are at "1" level, both the PMOSs 30 and 31 are turned off, and both the NMOSs 32 and 33 are turned on. Consequently, the operation is the same as above, the output terminal 39 being at "0" level.

While a 2-input NOR circuit is described in this embodiment, this conception can also be applied to 3-input, 4-input and generally k-input NOR circuits (k ≧ 2) which may be designed according to this invention.

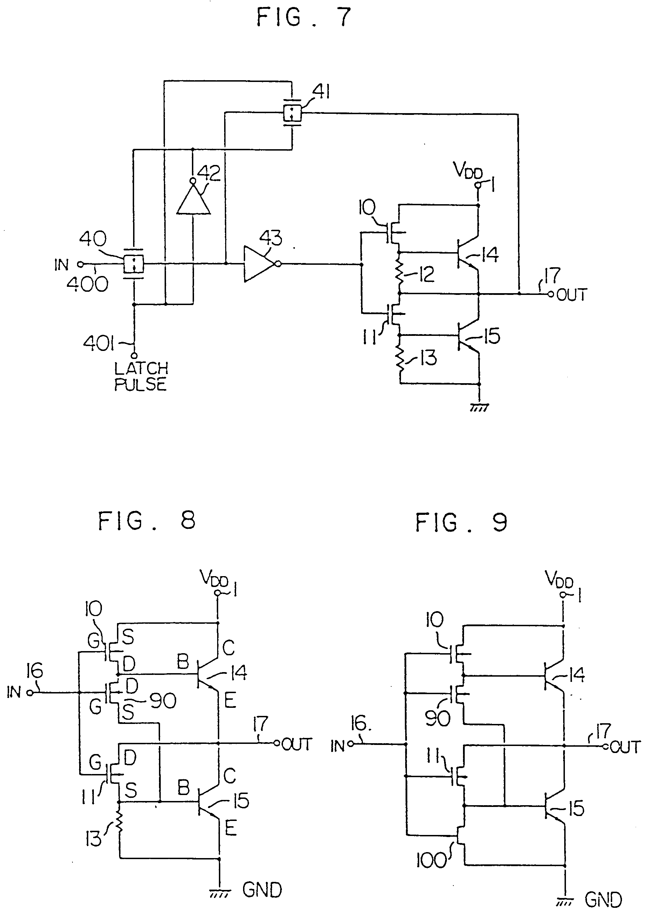

As an example for an application, Fig. 7 shows a latch circuit using at its output the inverter circuit shown in Fig. 3.

The circuit of Fig. 7 comprises a CMOS inverter 42 for reversing a latch pulse provided at terminal 401, a transfer gate 40 for transmitting data from the data input 400, a CMOS inverter 43 constituting a memory portion, and a transfer gate 41. Like elements corresponding to those of Fig. 3 are identified by the same reference numerals.

In order to latch the data from the data input 400, the latch pulse at terminal 401 is made "1". Then, the transfer gate 40 is turned on, and the transfer gate 41 is turned off, so that the data are written. Thereafter, when the latch pulse is made "0", the transfer gate 40 is turned off, and the transfer gate 41 is turned on. Consequently, the data are held by the inverter 43, the totem pole output type inverter and the transfer gate 41.

According to this embodiment, the latch circuit can be formed by the smallest configuration of a CMOS drive stage and two bipolar output stages as a high-speed, low-power consumption and high-density LSI.

Fig. 8 shows an inverter circuit according to the parent patent to which this invention can be applied.

In this embodiment, the resistor 12 shown in the embodiment of Fig. 3 is replaced by a second N-channel metal (silicon)-oxide-semiconductor field-effect transistor 90 (hereinafter, simply referred to as second NMOS 90), the NMOS 11 being the first NMOS. The second NMOS 90 has its gate electrode G connected to the input terminal 16, and its drain electrode D and its source electrode S connected to the drain electrode D of the PMOS 10 and the base electrode B of the second NPN transistor 15, respectively. Like elements corresponding to those of Fig. 3 are identified by the same reference numerals. The operation of the inverter of Fig. 8 is substantially the same as in the case of Fig. 3.

The circuit of Fig. 8 is different from that of Fig. 3 in that when the first NPN transistor 14 is turned off, or when the input terminal 16 is at "1" level, the second NMOS 90 is turned on, to discharge the charges accumulated in the first NPN transistor 14. Although in Fig. 3 the resistor 12 operates for this purpose, in this embodiment, the source electrode S of the second NMOS 90 is connected to the base electrode B of the second NPN transistor 15 so that the base current is increased to accelerate the switsching of the second NPN transistor 15 from the OFF-state to the ON-state. The source electrode S of the second NMOS 90 may be connected to the drain electrode D of the first NMOS 11.

In the first embodiment of Fig. 3 the current flows through the resistor 12 when the PMOS 10 is switched from the OFF-state to the ON-state, to delay the rise of the base potential of the first NPN transistor 14, and thus to somewhat delay the switching of the first NPN transistor 14 from the OFF-state to the ON-state, but in this embodiment when the PMOS 10 is turned on from the OFF-state the second NMOS 90 is turned off from the ON-state so that no current flows between drain and source of the NMOS 90. As a result, the base potential of the first NPN transistor 14 rises faster than in the first embodiment, to accelerate the switching of the NPN transistor 14 from the OFF- to the ON-state.

According to this embodiment, the second NMOS 90 is used in place of the resistor 12, so as to improve the integration density and the operation speed. Since the source S of the second NMOS 90 is connected to the base of the second NPN transistor 15, the operation speed is further improved.

Fig. 9 shows an inverter circuit according to the parent patent to which this invention can be applied.

In this embodiment, the resistor 13 of the circuit of Fig. 8 is replaced by a P-channel junction field-effect transistor (hereinafter, referred to as PJFET) 100 as a second P-channel field-effect transistor. The gate of the PJFET 100 is connected to the input terminal 16, and the source and the drain thereof are connected to the base and to the emitter of the second NPN transistor 15, respectively.

In Fig. 9, like elements corresponding to those of Figs. 3 and 8 are identified by the same reference numerals.

The embodiment of Fig. 9 is different from the circuit of Fig. 8 in that when the second NPN transistor 15 is turned off from the ON-state, or when the input terminal 16 is changed from level "1" to "0" level, the charges accumulated in the second NPN transistor 15 are extracted through the PJFET 100. When the charges are discharged, the ON-resistance of the PJFET 100 is decreased to accelerate the switching of the second NPN transistor 15 from the ON-state to the OFF-state. When the input terminal 16 changes from "0" to "1" level, the PJFET 100 is changed from the ON-state to the OFF-state, and thus the base current to the second NPN transistor 15 is not shunted so that the second NPN transistor 15 is rapidly turned on from the OFF-state.

This embodiment provides a much higher speed as compared with the previously described embodiments.

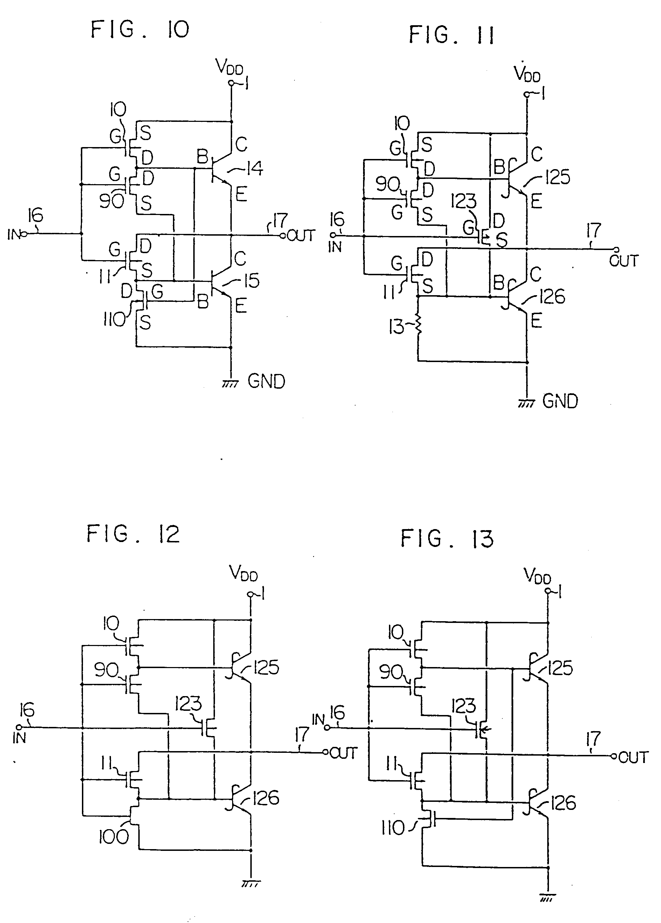

Fig. 10 shows an inverter circuit according to the parent application to which this invention can be applied.

In this embodiment, the resistor 13 in the circuit of Fig. 8 is replaced by a third M-channel metal oxide-semiconductor field-effect-transistor (hereinafter, referred simply as to third NMOS) 110. In Fig. 10, like elements corresponding to those of Figs. 3 and 8 are identified by the same reference numerals. The third NMOS 110 has its gate electrode G connected to the base electrode B of the first NPN transistor 14, and its drain electrode D and its source electrode S connected to the base electrode B and the emitter electrode E of the second NPN transistor 15, respectively.

This embodiment is different from the circuit of Fig. 8 in that when the second NPN transistor 15 is turned off from the ON-state, or when the input terminal 16 is changed from "1" to "0" level, the charges accumulated in the second NPN transistor 15 are extracted through the third NMOS 110. When the input terminal 16 is at "0" level, the high base potential of the first NPN transistor 14 is applied to the gate of the third NMOS 110, which then turns on to form short circuit between the base and emitter of the second NPN transistor 15, thus extracting the accumulated charges more rapidly.

According to this embodiment, since no resistor is used, a higher integration density can be achieved.

While some modifications of the inverter circuit of Fig. 3 are shown in Figs. 8, 9 and 10, this circuit conception can similarly be applied to multi-input NANDs such as in Fig. 5, multi-input NORs such as in Fig. 6 and latch circuits such as in Fig. 7.

The above described logic circuits can be used for implementation in LSIs according to this invention, which in turn can be applied to output buffer circuits for driving an external circuit. Examples of such applications are shown in Figs. 11, 12 and 13. Although these three examples are inverter circuits, the buffer circuit may also be a multi-input NAND or a multi-input NOR circuit.

Fig. 11 shows an inverter circuit according to a first embodiment of this invention. This circuit has substantially the same construction and operates in a similar manner as the circuit of Fig. 8.

In Fig. 11, like elements corresponding to those of Fig. 8 are identified by the same reference numerals. The circuit comprises a first NPN transistor 125 with a Schottky barrier diode provided between the base and collector as compared with the first NPN transistor 14 in Fig. 8, a second NPN transistor 126 with a Schottky barrier diode provided between the base and collector as compared with the second NPN transistor 15 of Fig. 8, and a fourth N-channel metal (silicon)-oxide-semiconductor field-effect-transistor (hereinafter, simply referred to as fourth NMOS) 123 having its gate electrode G connected to the input terminal 16 and its drain electrode D and its source electrode S respectively connected to the power supply terminal 1 and the base electrode B of the second NPN transistor 126.

This embodiment is different from the circuit of Fig. 8 in that the first and second NPNs 125 and 126, respectively, have a Schottky barrier diode added for the purpose of accelerating the time of extraction of accumulated charges, due to the saturation of the NPN transistors.

In addition, this embodiment is different from the circuit of Fig. 8 in that according to the invention the fourth NMOS 123 is provided between the power supply terminal 1 and the base electrode B of the second NPN transistor 126, with its gate electrode G being connected to the input terminal 16. This is because in the case of an output circuit, a sink current I_{OL} needs to be drawn in at a low-level output V_{OL}, and hence the second NPN 126 must be continuously supplied at its base with current at "1" level of the input terminal 16.

According to this embodiment of this invention, a high-speed, low-power consumption inverting output circuit can be realized.

Fig. 12 shows an inverter circuit according to a second embodiment of this invention. This circuit has substantially the same construction and operates in a similar manner as the circuit of Fig. 9.

In Fig. 12, like elements corresponding to those of Figs. 9 and 11 are identified by the same reference numerals. The resistor 13 in Fig. 11 is replaced by a PJFET 100 as in Fig. 9. This circuit is different from the circuit of Fig. 9 in that, as in the embodiment of Fig. 11, the first and second NPN transistors 125 and 126 have a Schottky barrier diode added, and in that the fourth NMOS 123 is provided for supplying current to the base of the second NPN transistor 126. According to this embodiment, an inverting output circuit operating at a much higher-speed can be realized.

Fig. 13 shows an inverter circuit of a third embodiment of this invention. This circuit has substantially the same construction and operates in a similar manner as the circuit of Fig. 10. In Fig. 13, like elements corresponding to those of Figs. 10 and 11 are identified by the same reference numerals. The resistor 13 in the circuit of Fig. 11 is replaced by the third NMOS 110. This embodiment is different from the circuit of Fig. 10 in that as in the first embodiment of Fig. 11, the first and second NPN transistors 125 and 126 have a Schottky barrier diode added, and in that the fourth NMOS 123 is provided for supplying current to the base of the second NPN transistor 126. According to this embodiment, inverting output circuits having a much higher integration density can be realized.

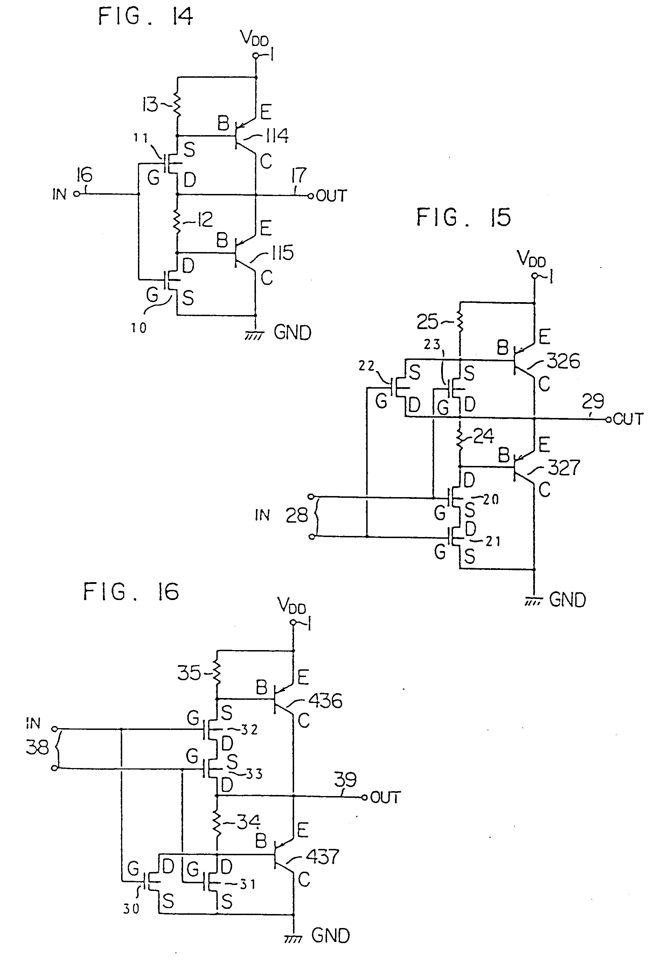

Fig. 14 shows an inverter circuit according to the parent patent to which this invention can be applied. This circuit comprises a bipolar PNP transistor (hereinafter, simply referred to as second PNP) 114 having its emitter electrode E connected to the power supply terminal 1 at which the fixed potential is kept, and its collector electrode C connected to the output terminal 17, and bipolar PNP transistor (hereinafter, simply referred to as first PNP) 115 having its emitter electrode E connected to the output terminal 17 and its collector electrode C connected to a fixed ground potential GND. The PMOS 11 has its gate electrode G connected to the input terminal 16, and its source electrode S and its drain electrode D respectively connected to the base electrode B and the collector electrode C of the second PNP transistor 114. The NMOS 10 has its gate electrode G connected to the input terminal 16 and its drain electrode D and its source electrode S respectively connected to the base electrode B and the collector electrode C of the first PNP transistor 115. The resistor 12 connects the drain electrode D of the PMOS 11 to that of the NMOS 10. The resistor 13 connects the base electrode B to the emitter electrode E of the second PNP transistor 114. In this embodiment, the bipolar NPN transistors 14 and 15 of the circuit of Fig. 3 are replaced by the bipolar PNP transistors 115 and 114, respectively, whereby the same operation is performed.

Fig. 15 shows a 2-input NAND circuit according to the parent patent to which this invention can be applied. This circuit comprises a second PNP transistor 326 having its emitter electrode E connected to the power supply terminal 1 and its collector electrode C connected to the output terminal 29, a first PNP transistor 327 having its emitter electrode E connected to the output terminal 29 and its collector electrode C connected to the ground potential GND, two input terminals 28, and PMOSs 22 and 23 having their gate electrodes G connected to one and the other of the input terminals 28, respectively, and their source-drain paths connected in parallel between the base electrode B and the collector electrode C of the second PNP transistor 326. In addition, it comprises NMOSs 20 and 21 having their gate electrodes G respectively connected to one and the other of the input terminals 28 and their drain-source paths connected in series between the base electrode B and the collector electrode C of the first PNP transistor 327, a resistor 24 connecting the drain electrode D of the PMOSs 22 and 23 with the drain electrode D of the NMOS 20, and a resistor 25 connecting the base electrode B and the emitter electrode E of the second PNP transistor 326.

In this circuit, the bipolar NPN transistors 26 and 27 in the circuit of Fig. 5 are replaced by the bipolar PNP transistors 327 and 326, respectively, whereby the same operation as in this embodiment is performed.

While a 2-input NAND circuit is described in this embodiment, this conception can also be applied to 3-input, 4-input or generally k-input NAND circuits (k ≧ 2), to which this invention is applicable.

Fig. 16 shows a 2-input NOR circuit according to the parent patent to which this invention can be applied.

The circuit comprises a second PNP transistor 436 having its emitter electrode E connected to the power supply terminal 1 and its collector electrode C connected to the output terminal 39, a first PNP transistor 437 having its emitter electrode E connected to the output terminal 39 and its collector electrode C connected to the ground potential GND, two input terminals 38, PMOSs 32 and 33 having their gate electrodes G connected to one and the other of the input terminals 38, respectively, and their source-drain paths connected in series between the base electrode B and the collector electrode C of the second PNP transistor 436, and NMOSs 30 and 31 having their gate electrodes G connected to one and the other of the input terminals 38, respectively, and their drain-source paths connected in parallel between the base electrode B and the collector electrode C of the first PNP transistor 437. In addition, it comprises a resistor 34 connecting the drain electrode D of the PMOS 33 to the drain electrodes D of the NMOSs 30 and 31, and a resistor 35 connecting the base electrode B to the emitter electrode E of the second PNP transistor 436.

In this circuit, the bipolar NPN transistors 36 and 37 in the circuit of Fig. 6 are replaced by the bipolar PNP transistors 437 and 436, respectively, whereby the same operation as in the third embodiment is performed.

While a 2-input NOR circuit is described in this embodiment, this conception can also be applied to 3-input, 4-input, or generally k-input NOR circuits (k ≧ 2), to which this invention is applicable.

It will easily be understood by those skilled in the art that the embodiments of Figs. 14, 15 and 16 can be modified as the embodiments of Figs. 7 to 13.

While in the above described embodiments the logic gates are only NAND and NOR circuits, it will easily be understood that other logic gate circuits such as AND and OR circuits, logic circuit combinations, flip-flops or shift registers can be formed by connecting a logic gate circuit of, for example, CMOS transistors to the input side of the NAND and NOR circuits.

According to this invention, as described above, it is possible to produce high-speed, low-power consumption gate circuits formed of field-effect and bipolar transistors, whereby a high density integration is possible.

## Claims

1. Composite bipolar transistor-CFET logic gate circuit comprising:
A) a bipolar transistor (14) having a collector of a first conductivity type connected to a first potential terminal (1), a base of a second conductivity type, and an emitter of the first conductivity type connected to an output terminal (17),
B) k(k ≧ 1) FETs (10) of the second conductivity type for forming a current path from the first potential terminal (1) to the base of the bipolar transistor (14), in response to input signals applied to the respective input terminal of k input terminals (16),
and
C) k switching means (11, 13, 15) connected between the output terminal (17) and a second potential terminal (GND), and connected to the input terminals (16),
characterized by
D) discharge means (12) connected to the base of the bipolar transistor (14) (e.g. Fig. 3).

2. The circuit according to claim 1, characterized in that the discharge means (12) are connected between the base of the bipolar transistor (14) and the output terminal (17) (Fig. 3).

3. The circuit according to claim 1 or 2, characterized by a CMOS circuit (43) connected with its output terminal to one of the input terminals (16) (Fig. 7).

4. The circuit according to claim 3, characterized in that the CMOS circuit (43) is an inverter circuit (Fig. 7).

5. The circuit according to one or more of claims 1 to 4, characterized in that the switching means comprise an NMOS (11) having its gate connected to the input terminal (16) (Fig. 3).

6. The circuit according to claim 4, characterized in that the output terminal (17) is connected via a transfer gate (41) to the input of the inverter circuit (43) (Fig. 7).

7. The circuit according to one or more of claims 1 to 6, characterized in that the discharge means (12) are a resistor.

8. The circuit according to one or more of claims 1 to 6, characterized in that the discharge means (12) are an NMOS (90) (Fig. 8).

9. The circuit according to one or more of claims 1 to 8, characterized in that the k FETs (10, 20, 21; 30, 31) of the second conductivity type have their gates connected to the corresponding input terminal (16; 28; 38), for k = 1 source and drain of the FET being connected between collector and base of the first bipolar transistor, respectively, and for k 2 their sources and drains being connected in parallel or in series between collector and base of the first bipolar transistor (14; 26; 36; 115; 327; 437), respectively.

10. The circuit according to one or more of claims 1 to 9, characterized in that the switching means (11, 13, 15) comprise:
- A second bipolar transistor (15; 27; 37; 114; 326; 436) having its collector being of the first conductivity type connected to the output terminal (17; 29; 39) and its emitter being of the first conductivity type connected to the second potential terminal (GND), and having a base of the second conductivity type,
- k second FETs (11; 22, 23; 32; 33) of the first conductivity type having their gates connected to the corresponding input terminal (16; 28; 38), for k = 1 drain and source of the FET being connected between collector and base of the second bipolar transistor, respectively, and for k ≧ 2 their drains and sources being connected in series or in parallel between collector and base of the second bipolar transistor (15; 27; 37), respectively,
and
- second discharge means (12; 13, 25; 35; 100, 110) connected to the base of the second bipolar transistor (15; 27; 37; 114; 326; 436).

11. The circuit according to claim 10, characterized in that the second discharge means are a resistor (12; 13; 25; 35), one terminal of the resistor being connected to the base of the second bipolar transistor (15; 27; 37; 114; 326; 436), the other terminal of the resistor being connected to the second potential terminal (GND).

12. The circuit according to one or more of claims 1 to 11, characterized in that the bipolar transistor (14) is implemented as a vertical type transistor formed as an island in a substrate (210) of the second conductivity type (Fig. 4).
